# FASCICULE DE BREVET EUROPEEN

(11) **EP 1 032 114 B1**
(45) Date de publication et mention de la délivrance du brevet: **26.10.2011**
(21) Numéro de dépôt: 00400512.0
(22) Date de dépôt: 25.02.2000
(51) Int. Cl.: H02K 11/04, H01L 25/11

(54) **Module électrique pour alternateur de véhicule, notamment automobile, et assemblage comportant un tel alternateur et un tel module**
Elektrisches Modul für Fahrzeug-, insbesondere Autolichtmaschine, und ein solches Modul und eine solche Lichtmaschine beinhaltende Anordnung
Electric module for vehicle alternator, in particular car alternator, and assembly featuring such an alternator and such a module

(30) Priorité: 10.11.1999 FR 9914124; 26.02.1999 FR 9902417
(43) Date de publication de la demande: 30.08.2000
(73) Titulaire: VALEO EQUIPEMENTS ELECTRIQUES MOTEUR, 94017 Créteil (FR)
(72) Inventeur: Arrighi, Sébastien, 78000 Versailles (FR); Thery, Laurent, 94120 Fontenay/S/Bois (FR); Volle, Corinne, 78000 Versailles (FR); Pfiffer, Jean Julien, 94000 Créteil (FR); Sebille, Dominique, 94110 Arcueil (FR); Vandenbossche, Mathieu, 75020 Paris (FR)
(74) Mandataire: Gamonal, Didier

(56) Documents cités:
- EP-A- 0 671 803
- EP-A- 0 746 083
- DE-A- 3 528 347
- DE-A- 4 403 996
- FR-A- 2 002 322
- FR-A- 2 486 323
- FR-A- 2 489 593
- JP-A- 60 031 257
- JP-A- 63 014 464
- US-A- 3 608 191
- US-A- 4 232 238
- US-A- 4 538 169

## Description

La présente invention est relative à un module électronique pour alternateur de véhicule, notamment automobile, et a un assemblage comportant un tel alternateur et un tel module.

Dans le document US-A-4,232,238, conforme au préambule de la revendication 1, on a proposé un module électronique, qui regroupe tout ou partie des fonctions électroniques associées à l'alternateur (redressement, antiparasitage).

Dans ce document, il est prévu un substrat isolé portant des éléments interrupteurs se présentant sous la forme de puces non encapsulées. Le substrat isolé porte également des moyens de régulation. En pratique les éléments interrupteurs, sous forme de puces, sont portés par des éléments qui définissent les branches du pont redresseur à diodes constituant un convertisseur de courant alternatif en courant continu, lesdites puces consistant en des diodes.

Le pont comporte donc deux séries d'interrupteurs, à savoir des diodes dites positives et des diodes dites négatives.

La Demanderesse s'est demandée s'il n'était pas possible d'optimiser encore ce module.

La présente invention a pour objet de répondre à ce souhait. Ce souhait est réalisé conformément à l'invention par la partie caractérisante de la revendication 1.

Grâce à l'invention les éléments interrupteurs à puces peuvent être identiques. En effet dans le document US-A-4,232,238, on voit à la lumière des figures 7 et 8 que les puces ne sont pas du même type.

Un risque d'erreur existe donc lors du montage. En outre il faut stocker deux types de puces.

Grâce à l'invention on a besoin que d'un type de puce, en sorte que les risques d'erreurs n'existent plus. En outre cela conduit à une standardisation des puces et donc à une réduction des coûts en sorte que la solution est simple et économique. Les puces sont similaires. Elles peuvent varier par leur métallisation.

Le document JP 63 014 464 divulgue également un module électronique conforme au préambule de la revendication 1. De plus, ses éléments interrupteurs à puce y sont montés sur des éléments électriquement conducteur rapportés sur une trace conductrice du substrat isolé.

Les connexions électriques sont également simplifiées par le demi-pont.

Tout cela conduit à une réduction des défauts et donc à une plus grande fiabilité du module.

En outre, grâce à l'invention, on peut réduire l'encombrement en sorte que l'on optimise encore le module.

Cela provient du fait de la formation d'un demi pont avec une même série de puces, alors que dans l'art antérieur les puces étaient montées sur les branches du pont redresseur.

Grâce à l'invention on peut utiliser des puces de diodes et également des puces de transistor MOS-FET permettant d'obtenir un alternateur faisant également démarreur, la machine électrique étant alors réversible. Bien entendu on peut utiliser d'autres types de puces commandables telles que des puces de thyristors.

Dans une forme de réalisation, l'autre série de puces est montée également sur un deuxième élément électriquement conducteur pour former l'autre demi-pont. Il suffit alors de retourner les puces d'un demi-pont à l'autre.

Dans une deuxième forme de réalisation, la deuxième série de puces est montée sur des éléments conducteurs reliés chacun à l'une des phases de l'alternateur.

Chaque puce de la première série est reliée, par sa face supérieure, à l'élément conducteur concerné, les deuxièmes puces étant connectées, par leur face supérieure, à un même élément conducteur.

Ainsi les puces sont toutes posées dans le même sens en sorte qu'il n'y a pas à les retourner. Ces puces peuvent donc être toutes identiques.

Les risques d'erreur et donc de défauts sont encore réduits. En outre les puces peuvent encore être simplifiées, du fait qu'elles se montent toutes dans le même sens.

On réduit donc encore les coûts.

Suivant d'autres caractéristiques de manière simple les éléments interrupteurs à puces d'un demi-pont sont brasés sur une même pièce métallique rapportée sur une trace métallique du substrat, pour formation d'une connexion électrique et obtention d'un maintien mécanique des puces;
- une pièce métallique est brasée au dessus d'une puce ;
- une pièce intermédiaire est interposée entre un élément interrupteur et une connexion électrique;
- le substrat comporte une zone non isolée ;
- il comporte un capot apte à fermer l'enceinte.
- l'enceinte intègre des moyens de connexion à un porte-balais.
- il comporte un porte-balais.

L'invention propose également un assemblage comportant un alternateur et un module électronique du type précité.

Avantageusement :
- le module est plaqué sur le palier arrière de l'alternateur.
- le refroidissement par eau ou par air de l'alternateur est apte à refroidir les éléments formant diodes.

On notera que la solution proposée permet une plus grande intégration, d'où un encombrement réduit :
- en surface à l'arrière de l'alternateur (actuellement l'électronique occupe¾ de la surface, la solution occupe seulement la moitié), ce qui permet un positionnement plus « mobile » sur l'arrière et donc une polyvalence vis à vis des demandes client (position des bornes)
- en épaisseur, ce qui permet un meilleur accès pour la fixation du câblage du véhicule sur les bornes de l'alternateur.

Le nombre de pièces à assembler est réduit et les pièces sont plus simples, ce qui facilite l'assemblage et le montage.

Actuellement, les diodes encapsulées pour l'électronique de puissance dans les alternateurs sont fabriquées par peu de fournisseurs. L'utilisation de puces de diodes - non encapsulées - ou de transistors MOSFET non encapsulés ou d'autres puces commandables permet l'élargissement des fournisseurs potentiels, d'où une plus grande souplesse.

Par puce de diode, on entend ici tout composant semi-conducteur qui, grâce à un dopage adéquat de ses couches, intègre la fonction diode.

Il en est de même en ce qui concerne les transistors du type MOSFET, les thyristors etc.

L'utilisation des pièces de cuivre supérieures et inférieures permet d'optimiser la thermique de l'ensemble aussi bien en statique qu'en transitoire. Les traces conductrices du substrat jouent donc un rôle supplémentaire de fixation de ces demi-ponts.

Egalement, le substrat peut intégrer le condensateur d'antiparasitage.

La solution permet l'utilisation de composants CMS.

Le module peut se fixer de manière optionnelle sur la partie arrière (côté collecteur) ou avant (côté poulie) de l'alternateur, que celui-ci soit refroidi par air ou par eau. Il peut être dans un boîtier électronique séparé.

D'autres caractéristiques et avantages de l'invention ressortiront encore de la description qui suit. Cette description est purement illustrative et non limitative. Elle doit être lue en regard des dessins annexés sur lesquels :
- les figures 1a, 1b et 1c illustrent différents montages redresseurs possibles en sortie d'un alternateur ;
- la figure 2 est une représentation schématique en coupe illustrant un montage possible d'une diode sur un substrat isolé ;
- la figure 3 est une représentation schématique en vue de dessus illustrant un circuit électronique présentant deux zones, l'une isolée, l'autre non isolée ;
- les figures 4 et 5 illustrent deux montages à convertisseur de courant alternatif en courant continu selon une caractéristique de l'invention ;
- la figure 6 est une représentation d'un circuit comportant un pont redresseur et un régulateur ;
- les figures 7a et 7b sont des représentations schématiques en coupe et en vue de dessus illustrant un montage d'un demi-pont de diodes ;
- la figure 8 est une représentation d'un détail du circuit de la figure 6, sans ses diodes ;
- les figures 9a à 9c illustrent différents types de connexion possibles avec les entrées phase ;
- les figures 10 et 11 sont des représentations schématiques illustrant différents types de mise à la masse ;
- les figures 12a et 12b illustrent différents montages possibles pour la connexion de phase ;
- les figures 13a et 13b illustrent différents montages possibles de connexions possibles avec la sortie B⁺ ;
- la figure 14 illustre en vue en coupe un module selon un mode de réalisation de l'invention comportant une enceinte et capot fermant celle-ci ;
- la figure 15a est une représentation schématique illustrant la disposition d'un module selon un autre mode de réalisation de l'invention
- la figure 15b illustre un porte - balais rapporté sur ce module ;
- les figures 15c à 15e illustrent différents types de moyens de connectique intégrés dans une paroi d'enceinte d'un module ; .
- les figures 16a et 16 selon encore un autre mode de réalisation de l'invention illustrent différents types de fermetures possibles pour l'enceinte ;
- les figures 17a et 17b illustrent le montage d'un module sur un palier d'alternateur, notamment pour véhicule automobile.

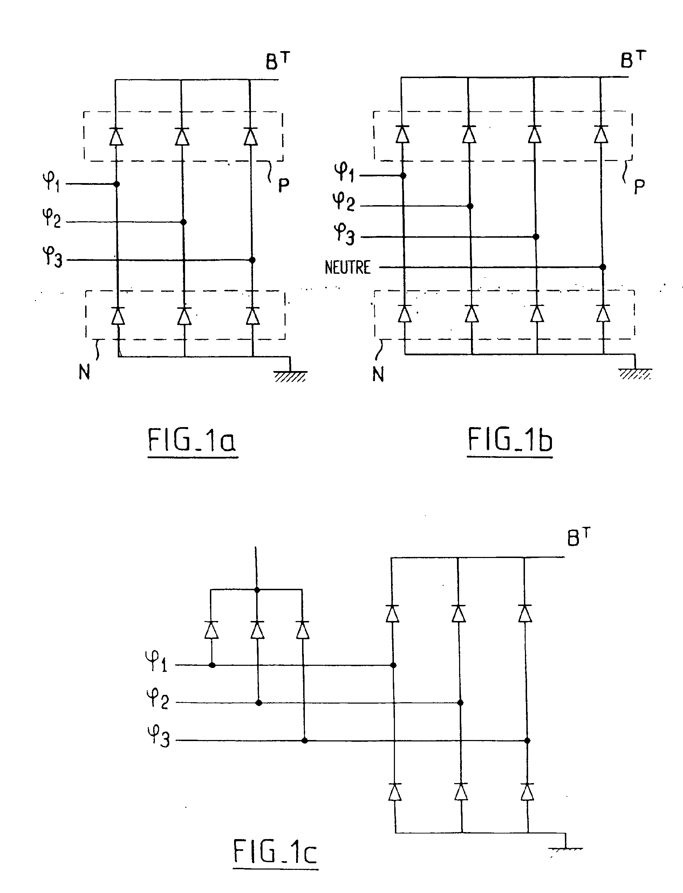

Dans une solution conforme à un mode de réalisation possible de l'invention, un module électronique comporte un substrat isolé qui porte un circuit qui intègre un convertisseur permettant de transformer un courant alternatif en courant continu. Dans cette solution le convertisseur est un pont redresseur, lequel est par exemple du type d'un de ceux représentés sur les figures 1a, 1b et 1c.

. Sur la figure 1a, le pont redresseur est constitué de deux demi-ponts de trois diodes chacun, l'un relié à la masse (demi-pont négatif N), l'autre relié à une borne de sortie (demi-pont positif P). Les diodes de ces demi-ponts N et P sont reliées aux trois sorties de phase ϕ1, ϕ2, ϕ3 de l'alternateur.

Sur la figure 1b, les deux demi-ponts N et P sont constitués chacun de quatre diodes, leurs diodes étant reliées aux sorties de phase ϕ1, ϕ2, ϕ3 de l'alternateur et au neutre (cas d'un bobinage stator en étoile).

Sur la figure 1c, le pont redresseur est du type de celui représenté sur la figure 1a et il est également prévu un demi-pont supplémentaire de trois diodes dont la sortie est par exemple injectée en entrée d'un régulateur associé à l'alternateur.

Les diodes utilisées pour constituer ces ponts redresseurs sont par exemple des diodes Zener ou haute tension, qui sont éventuellement encapsulées, mais qui sont préférentiellement des puces de diodes, ici identiques, suivant une caractéristique de l'invention.

En variante ces puces de diodes sont remplacées par des puces de transistors commandées du type MOS-FET comportant de manière connue une source, un drain et une grille. Les puces sont à base de matériau semi-conducteur.

Dans tous les cas le convertisseur comporte des puces ici non encapsulées formant des interrupteurs. Ces interrupteurs sont du type commandés (transistors MOS-FET) ou non commandés (les diodes).

L'alternateur peut donc être du type réversible lorsque le convertisseur comporte des interrupteurs commandés et constituer donc également un démarreur pour le véhicule automobile.

Dans tous les cas les puces sont similaires. Elles peuvent varier par leur métallisation. En variante elles peuvent être toutes identiques.

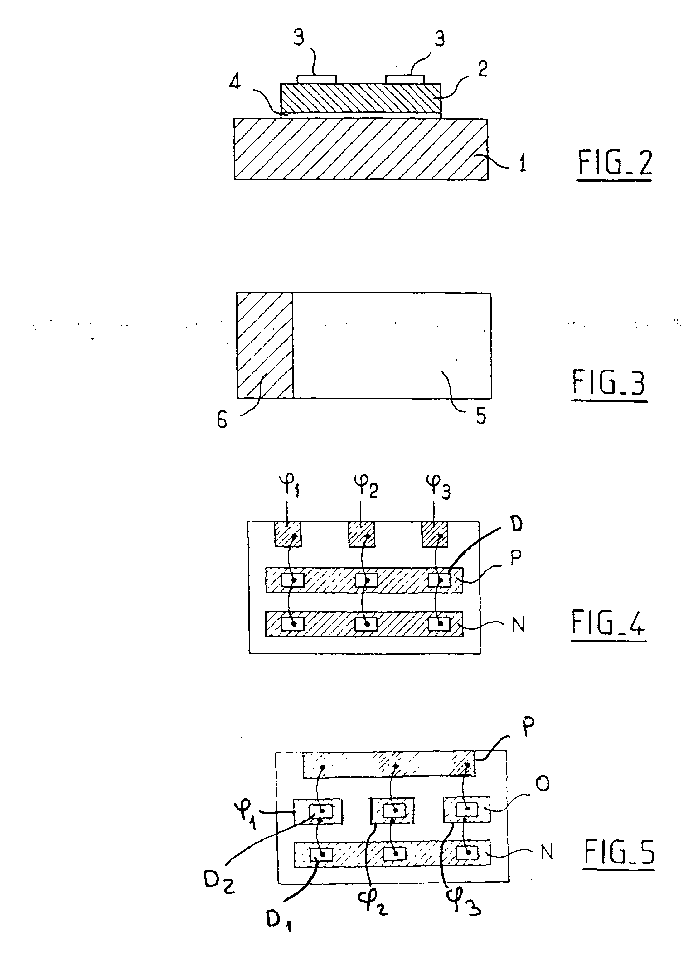

Le substrat isolé peut par exemple être réalisé par les différentes techniques suivantes :
- SMI (substrat métallique isolé), consistant en une semelle métallique recouverte d'un isolant polymère puis d'une feuille de matériau conducteur, qui est ensuite gravée pour former le circuit électrique ;
- Sérigraphie sur acier inoxydable, consistant en une semelle en acier inoxydable recouverte d'un verre isolant puis d'une encre conductrice déposée par sérigraphie pour former le circuit électrique ;
- Sérigraphie sur aluminium, consistant en une semelle en aluminium recouverte d'un isolant puis d'une encre conductrice, le tout déposé par sérigraphie pour former le circuit électrique ;
- Sérigraphie sur céramique, consistant en une semelle en céramique recouverte d'encre conductrice déposée par sérigraphie pour former le circuit électrique ; cette semelle céramique est reportée sur un dissipateur en cuivre ou en aluminium ;
- technique dite "DBC" ou "Direct Bonded Copper" selon la terminologie anglo-saxonne généralement utilisée par l'homme du métier, consistant en deux feuilles de conducteur pressées à chaud sur une plaque de céramique ; le conducteur est ensuite gravé pour former le circuit électrique et le tout est reporté, ainsi que l'illustre la figure 2, sur un dissipateur en cuivre ou en aluminium. Sur cette figure 2, le dissipateur en cuivre a été référencé par 1, la plaque de céramique par 2, les pistes gravées par 3, et par 4 la feuille de conducteur interposée entre l'embase qui constitue le dissipateur en cuivre 1 et la plaque de céramique 2.

Dans le cas des substrats à embase métallique, le substrat peut présenter des zones de conduction électrique sélectives pour réaliser le retour masse. C'est ce qu'illustre la figure 3 sur laquelle on a référencé par 5 une zone dans laquelle le circuit est isolé par rapport à l'embase métallique et par 6 une zone dans laquelle des connexions à l'embase métallique sont possibles.

Dans le cas d'un substrat de type "DBC" ou Céramique, le retour de masse peut se faire par des vias métalliques qui traversent la semelle ou plaque de céramique.

Le montage du convertisseur de courant alternatif en courant continu sous forme d'un pont redresseur à la figure 4 est réalisé en montant sur le circuit deux barrettes de diodes constituant chacune un demi-pont P,N. Les diodes D sous la forme de puces de diodes sont identiques entre elles. Elles sont retournées d'un demi-pont à l'autre.

Les diodes D, d'une part, sont fixées en-dessous du demi-pont plus précisément à la barrette électriquement conductrice de celui-ci, et, d'autre part, au-dessus sont reliées entre elles ainsi qu'à une plage électriquement conductrice, ici en forme de plot, connectée à l'une des phases comme visible à la figure 4.

Les deux séries de puces sont donc montées sur deux éléments électriquement conducteurs pour définir deux demi-ponts.

A la figure 5, les puces de diodes sont toutes dans le même sens. Trois des puces de diodes, dites première diode D1, sont fixées en-dessous pour définir un demi-pont par exemple N. Plus précisément elles sont fixées en-dessous sur la barrette électriquement conductrice de celui-ci. Au-dessus ces premières diodes sont reliées chacune de manière indirecte à l'une des trois autres puces de diode, dite deuxième diode D2, reliée elle-même à l'une des phases.

Ici les premières diodes D1 sont reliées, par leur face supérieure, à une plage électriquement conductrice, ici en forme de plot, elle-même reliée à la phase concernée.

C'est sur cette plage 0 qu'est fixée en-dessous la seconde diode concernée. Les faces supérieures des secondes diodes D2 sont reliées à l'autre demi-pont ici P plus précisément à une barrette électriquement conductrice de celui-ci.

On appréciera que les puces sont simplifiées car c'est la même face de la puce qui est fixée respectivement sur l'un des demi-ponts, sur la plage B concernée.

Il n'y a donc pas besoin de retourner la puce.

L'architecture illustrée sur les figures 4 et 5 peut bien entendu être dupliquée, de façon à disposer de ponts redresseurs à deux fois six (ou deux fois huit) diodes pour les machines de forte puissance.

On obtient dans tous les cas une solution compacte.

Egalement, on peut braser plusieurs puces en parallèle, ce qui permet de mettre le nombre de puces nécessaires pour s'adapter à la thermique et au débit de l'alternateur.

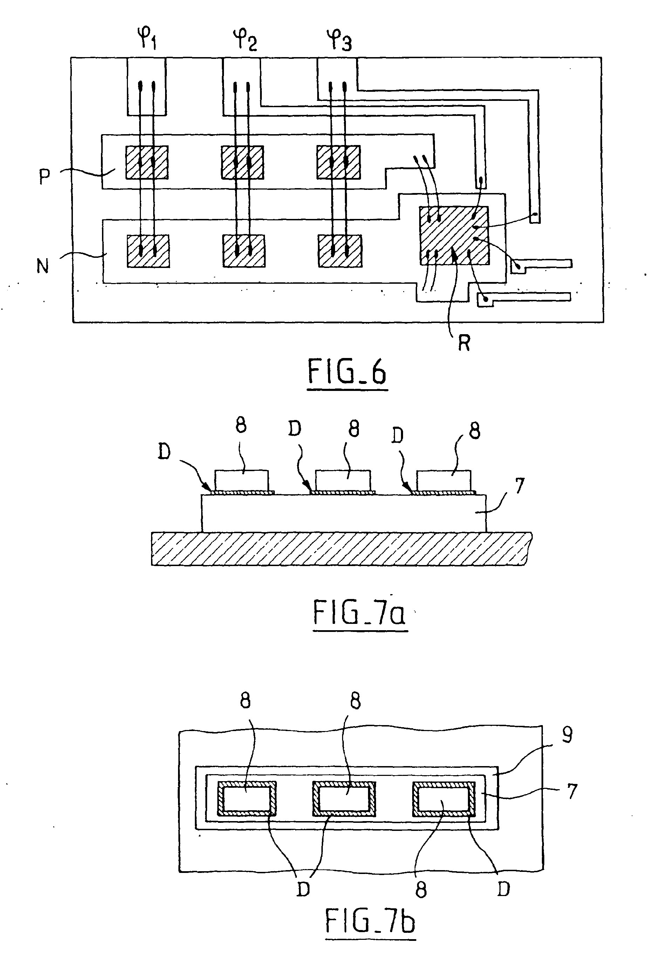

Le montage précédemment décrit peut intégrer un montage régulateur sur le même substrat (figure 6) ou sur un substrat indépendant.

Ce régulateur (R sur la figure 6) peut être réalisé avec une technologie hybride ou avec un circuit intégré ASIC.

L'assemblage du circuit sur le substrat peut se faire de la façon suivante.

Les trois ou quatre puces qui constituent les diodes D de chaque demi-pont sont brasées sur une pièce commune 7 en cuivre ou cuivre-invar-cuivre ou cuivre-carbone (figures 7a et 7b). Cette pièce 7 permet la conduction du courant vers la sortie B+ ou vers la masse tout en limitant les pertes Joule. Elle permet aussi de maintenir la température des puces en dessous de la température de jonction maximum en évacuant la chaleur vers le substrat. En variante la pièce 7 est en aluminium. L'épaisseur de cette pièce dépend des applications et notamment de la chaleur à évacuer.

Pour chaque diode D, une pièce 8 en cuivre ou cuivre nickelé ou aluminium nickelé ou aluminium argenté est brasée sur le dessus de la puce pour permettre la connexion électrique et pour assurer la tenue des puces, notamment dans le cas où l'alternateur se déconnecte de la batterie et se décharge plein champ ("Load dump" selon la terminologie anglosaxonne généralement utilisée par l'homme du métier) (figure 7a et 7b). Cette pièce 8 joue le rôle de capacité thermique.

La pièce 8 peut avoir l'épaisseur désirée pour bien évacuer la chaleur.

La pièce commune 7, sur laquelle sont brasées les trois ou quatre puces d'un demi-pont, est brasée ou collée sur une trace conductrice du substrat (piste 9). La trace conductrice 9 a donc un rôle de tenue et de fixation mécanique de ces pièces en plus de son rôle initial de conduction électrique.

Le montage de ces pièces (pièce commune sous les puces, pièce sur la puce et puce) sur le substrat peut être réalisé :
- en une fois, par refusion d'un alliage de brasure haute température (point de fusion > 290°C).
- en deux fois par refusion d'un alliage haute température de chaque côté de la puce, puis par report de la pièce commune sur le substrat avec un alliage de brasure plus basse température (180°C< point de fusion< 250°C) ou par une colle conductrice électrique et thermique. Cette solution permet de réaliser les demi-ponts indépendamment de la chaîne d'assemblage du module (en interne ou en externe).

On utilise un alliage haute température de chaque côté de la puce pour permettre l'utilisation à une température de jonction du composant maximale (200°C<Tjmax<240°C).

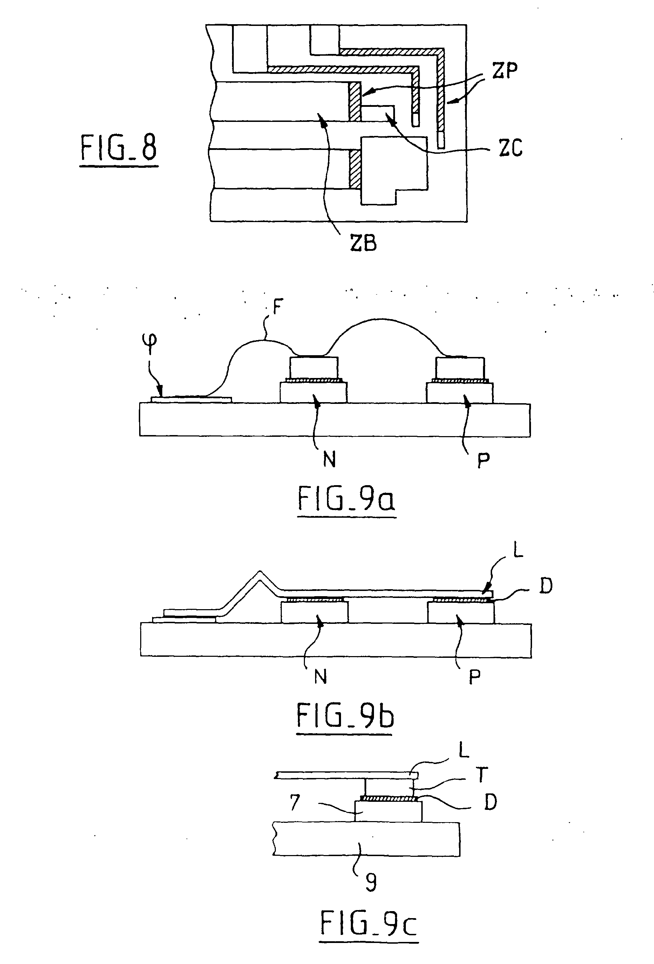

Les pistes conductrices du substrat peuvent être protégées par une couche protectrice pour faciliter les étapes du montage (isoler les zones de câblage des zones de brasage) et protéger le circuit des agents extérieurs. Sur la figure 8, on a référencé par ZP les zones protégées, par ZC les zones de câblage, par ZB les zones de brasage.

La connexion entre les entrées phase ϕ et les diodes D et entre les traces et le régulateur peuvent être réalisées par câblage ultrasonique de fils métalliques F (figure 9a) ou par des lamelles L conformées en pontet (figure 9b) ou par toute autre connexion. Dans le cas d'un pontet, il peut être prévue une pièce intermédiaire I entre une diode D et un pontet L (figure 9c).

Dans tous les cas, le ou les éléments de connexion sont dimensionnés pour assurer une tenue du pont redresseur en cas de "Load Dump".

Le câblage ultrasonique peut être réalisé directement sur la trace ou sur une pièce intermédiaire rapportée sur cette même trace, ceci afin de protéger le substrat de toute détérioration liée au câblage ultrasonique).

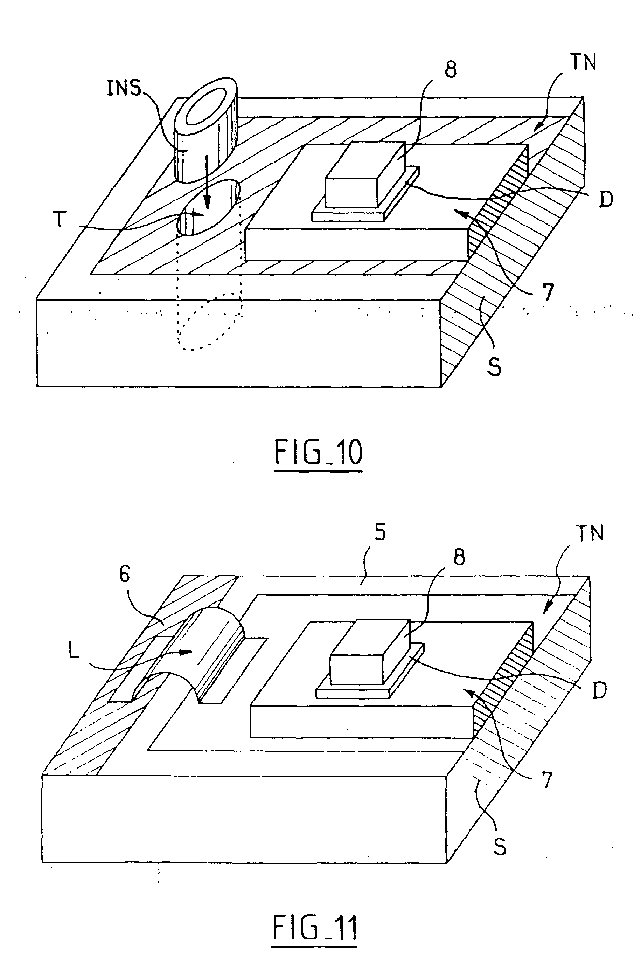

Le retour de masse de la trace conductrice vers le palier de l'alternateur peut être réalisé par :
- un ou plusieurs inserts métalliques INS, maintenus en appui sur la trace de masse TN par une vis traversant le ou les inserts et le substrat S (trou T) pour aller se visser dans le palier ou dans la pièce sur laquelle on fixera le substrat (figure 10). La vis peut être remplacée par un rivet.
- une zone non isolée sur le substrat métallique (figure 11) ; la connexion entre cette zone et la trace conductrice peut être réalisée par brasage d'une pièce telle qu'une lamelle L formant pontet et/ou par câblage ultrasonique.
- un via à travers les substrats céramique ou "DBC".

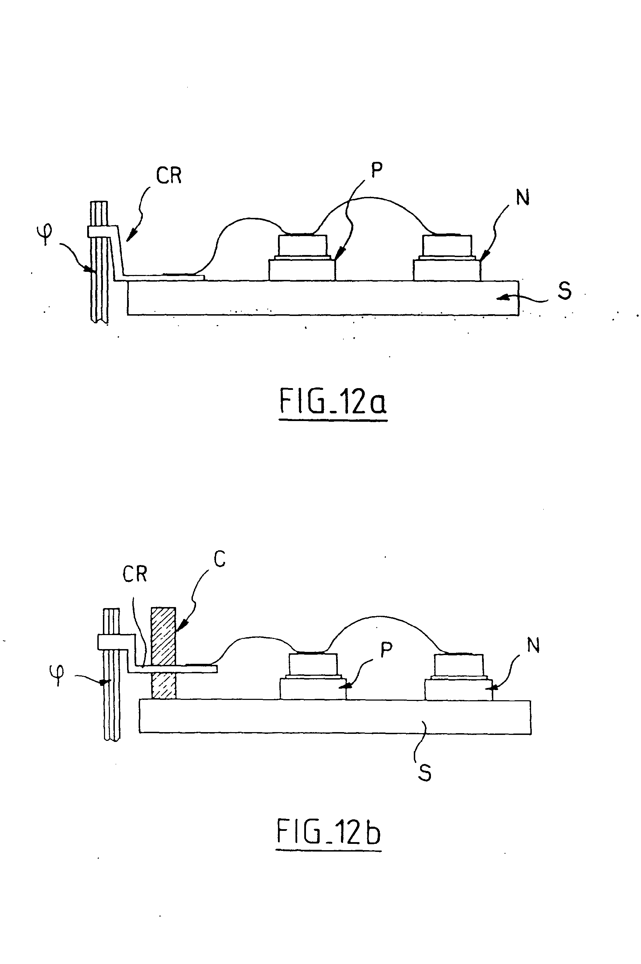

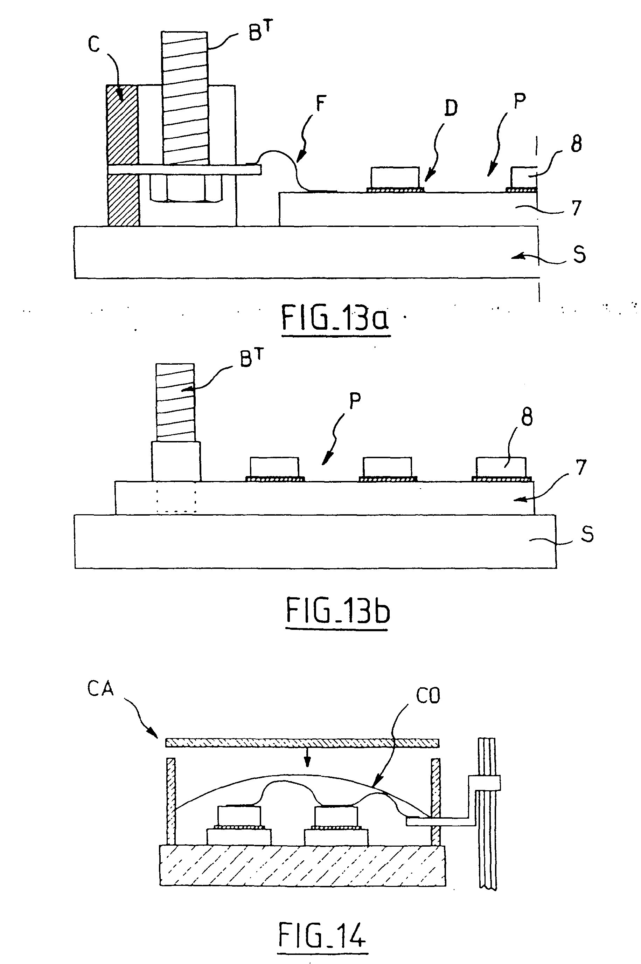

L'arrivée phase peut être quant à elle être réalisée:
- à l'aide de crochets CR directement fixés sur le substrat (figure 12a),
- par câblage ultrasonique entre les crochets intégrés à un 5 connecteur selon l'invention et des plots de câblage sur le substrat (figure 12b),
- par brasage des crochets intégrés au connecteur sur les plots du substrat,
- par soudure électrique entre les crochets intégrés au connecteur et une pièce brasée sur le substrat.
   10 Le connecteur C est par exemple ici une pièce plastique ceinturant le substrat S pour formation d'une enceinte.
   La connexion entre les fils de phase issus du stator et ces crochets peut être réalisée par brasage ou soudure électrique ou sertissage à chaud ou sertissage à froid. '
   15 La connexion électrique vers la sortie B+ peut se faire (figure 13) :
- par câblage ultrasonique ou par brasage d'un pontet vers une borne B+ séparée du substrat, par exemple disposée dans un connecteur plastique dans lequel est surmoulée selon un mache de réalisation de l'invention. Une trace métallique auquel le câblage filaire ou le pontet est relié (figure 13a),
- par une borne intégrée à la pièce commune 7 du pont positif P (borne emmanchée ou rivetée ou par tout autre technique) (figure 13b).

Le condensateur d'antiparasitage peut être intégré sur le substrat entre le B+ et la masse par collage ou brasage. Il peut être remplacé par des condensateurs de capacité plus faible en parallèle des diodes, ce qui permet l'utilisation de composants CMS.

Pour des raisons de tenue thermique, l'intégration du régulateur sur le même substrat que le redresseur peut être critique. Il peut alors être implanté sur le connecteur ceinture ou dans un porte-balais séparé comme il existe actuellement.

La protection mécanique et chimique du substrat peut être réalisé par:
- un gel hydrophobe, un connecteur ceinture et un capot ; c'est ce qui est illustré sur la figure 14, sur laquelle on a représenté d'une part un capot CA rapporté sur une ceinture C intégrant en l'occurrence la connexion de phase et d'autre part une protection des puces et pistes du circuit au moyen d'un gel de couverture CO ;
   - un gel hydrophobe et un capot
   - un surmoulage plastique.
Le gel peut être remplacé par un film ou tout autre produit convenant à la protection des circuits électroniques.
Le gel peut être facultatif si l'encapsulation est réalisée hermétiquement.
Un connecteur en plastique peut être fixé sur le substrat par collage ou clipsage ou rivetage plastique ou vissage ou soudure plastique.
Le connecteur ceinture le substrat et présente des traces surmoulées ou clipsées permettant :
   - d'y fixer les fils de phase et d'amener le courant vers le substrats (exemple : figure 12) et en variante
   - d'assurer l'interface entre le régulateur et le porte-balais et entre le régulateur et la connectique client
   - le montage de la capacité de filtrage
   - la transmission du courant vers la batterie et le réseau de bord (borne intégrée à la trace) (exemple : figure 13).

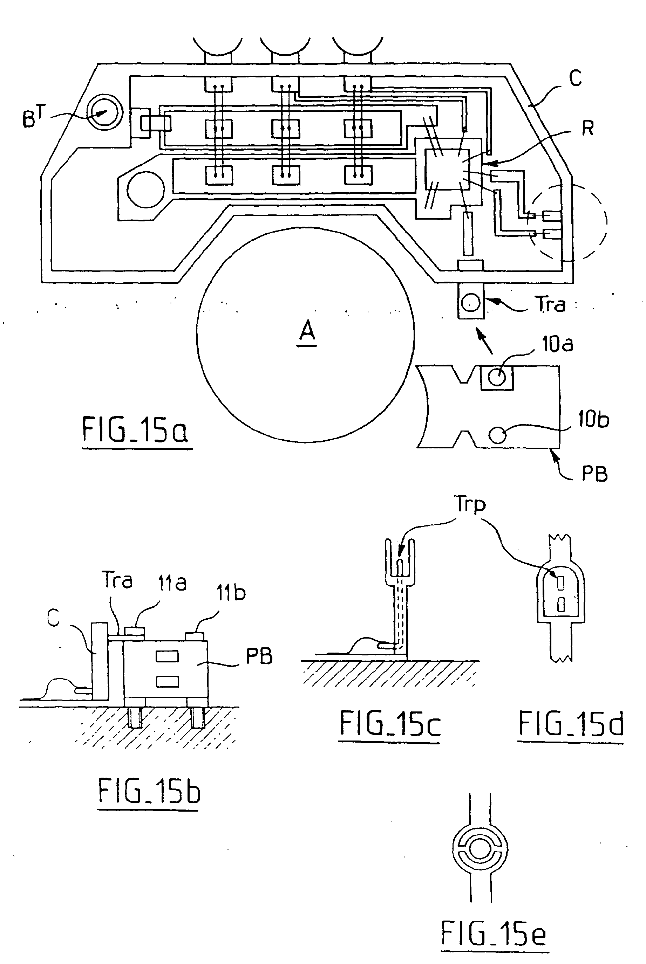

Un exemple de réalisation de connecteur ceinture C formant une enceinte a été illustré sur la figure 15a. On a également représenté sur cette figure 15a les différentes interfaces de ce connecteur et du circuit qu'il entoure avec différents éléments situés au voisinage du palier arrière de l'alternateur.

En particulier, on a représenté sur la figure 15a l'axe A du rotor de l'alternateur et un porte-balais PB destiné à être monté sur une trace surmoulée Tra qui s'étend en saillie à l'extérieur de la ceinture C.

Ainsi que l'illustre la figure 15b, le porte-balais PB présente deux trous de fixation 10a, 10b destinés à être traversés par des vis aptes à assurer la fixation du porte balais sur le palier arrière de l'alternateur.

L'une de ces deux vis (vis 11a sur la figure 15b) est passée à travers la trace Tra et assure la transmission au porte-balais du courant d'excitation généré par le régulateur R.

Elle est fixée sur le palier par l'intermédiaire d'un insert isolant.

L'autre vis (vis 11b sur la figure 15b) est totalement métallique et assure la mise à la masse.

En variante, le porte-balais pourrait être intégré au module protégé par la ceinture.

Par ailleurs, on a représenté sur les figures 15c et 15 d d'une part et sur la figure 15e d'autre part des formes de connecteurs pouvant être ménagés dans la ceinture du module qui peuvent être envisagés pour permettre de raccorder le circuit au reste du réseau électrique de la voiture afin de pouvoir échanger les informations.

Sur les figures 15c et 15d, la référence Trp désigne une trace du circuit repliée pour s'étendre dans la hauteur de la ceinture, puis dans le connecteur.

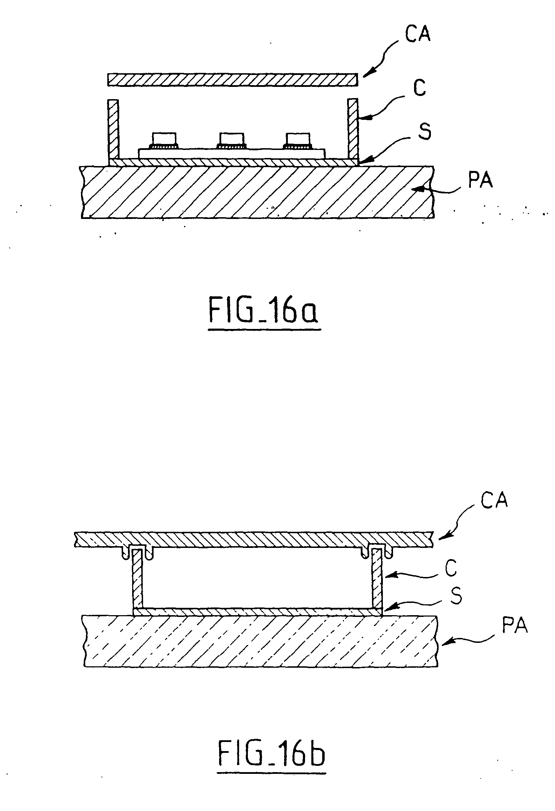

Ce connecteur ceinture peut être recouvert d'un capot, qui peut être :
- une pièce rapportée sur le dessus (par exemple, collée ou soudée ou vissée) (figure 16a, sur laquelle on a référencé par PA le palier sur lequel le module est monté),
- une forme spécifique dans le capot de l'alternateur qui viendrait fermer le module lors de l'assemblage (figure 16b); un joint peut alors être ajouté dans le rainurage du capot pour parfaire l'étanchéité.

Par ailleurs, le connecteur ceinture peut aussi être rempli par un produit durcissable.

Egalement, dans le cas où les connexions sont fixées sur le substrat, la protection du module peut être réalisée par un capot plastique fixé au dessus ou par surmoulage (par exemple compression-transfert).

L'assemblage du module du module qui vient d'être décrit avec les éléments du palier arrière de l'alternateur se fait de la façon suivante.

Le module peut être plaqué sur le palier ou sur un radiateur. Il peut être monté sur un alternateur refroidi par air ou par eau.

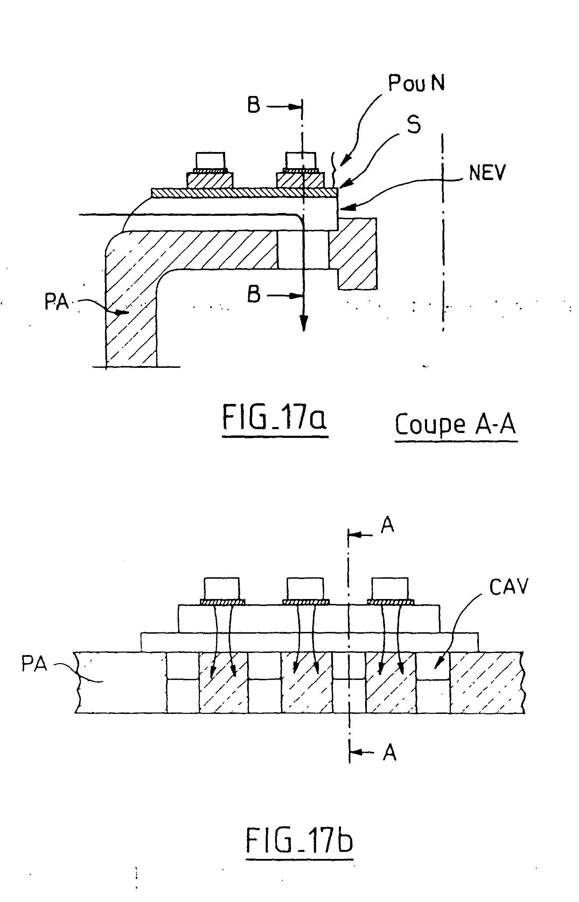

Le substrat S peut être plaqué sur toute sa surface ou localement, notamment sur des nervures NEV du palier PA (figure 17a - 17b). On s'efforce d'avoir toujours de la matière sous les puces de puissance.

Ces nervures NEV assurent un refroidissement des puces via le palier PA. Egalement, il peut être prévu que des canaux de ventilation CAV traversent le palier.

Le module est fixé par collage ou vissage.

Dans le cas où la connectique client n'est pas intégrée au module porte-balais, celle-ci peut être intégrée au capot de l'alternateur qui comporte alors des traces surmoulées ou clipsées. Ceci permet d'avoir une architecture standardisée au niveau du module, le capot étant la seule pièce s'adaptant aux demandes client.

On appréciera la compacité du module selon l'invention. A la lumière des figures 6 et 15a, on voit que le palier arrière de l'alternateur est plus dégagé que dans l'art antérieur du fait de la compacité du module, en sorte que l'alternateur est mieux refroidi par air.

Un avantage de cette compacité résulte du fait que le module constitue une plaque susceptible de délimiter localement de manière étanche le circuit d'eau de l'alternateur dans le cas ou celui-ci est refroidi par eau.

Il en résulte que les puces sont bien refroidies.

Dans tous les cas les puces non encapsulées de diodes ou de transistors MOS-FET sont fixées sur un élément électriquement conducteur.

Plus précisément le module électronique comporte un convertisseur de courant alternatif en courant continu comportant deux séries d'interrupteurs à puces.

Selon l'invention au moins une desdites séries est montée sur un élément électriquement conducteur pour définir un demi-pont.

En variante les puces peuvent consister en des thyristors ou en des transistors IGBT ou en des transistors bipolaires.

Bien entendu à la figure 5 la barrette P peut être surmoulée dans un connecteur formant ceinture, ce qui permet de diminuer la taille du substrat.

Bien entendu, au lieu d'une brasure à haute température, on peut utiliser une colle conductrice thermiquement et électriquement et résistante à la température.

Dans les figures 7a et 7b, on peut supprimer la pièce 8, la tenue au «Load dump» étant assurée uniquement par la pièce 7.

A la figure 5 les puces peuvent être rigoureusement identiques car on n'a pas à retourner les puces.

A la figure 4 les puces sont similaires.

## Revendications

1. Module électronique pour alternateur de véhicule, notamment automobile, doté de fils de phase, comportant un circuit qui intègre un convertisseur de courant alternatif en courant continu (P,N, D) doté d'éléments interrupteurs (D) portés par un substrat (S) isolé, dans lequel les éléments interrupteurs (D) se présentent sous la forme de deux séries de puces non encapsulées, **caractérisé en ce qu'**au moins une première des deux séries desdits premier éléments interrupteurs à puces est montée sur un premier élément électriquement conducteur (7) pour définir un premier demi-pont (P,N), **en ce que** le premier élément électriquement conducteur (7) est rapporté sur une trace conductrice (9,TN) du substrat (S) isolé, **en ce que** le substrat (S) porte une enceinte (C) en un matériau plastique qui entoure le circuit que porte le substrat et qui intègre des moyens de connectique comprenant des traces surmoulées ou clipsées formant des crochets (CR) pour fixation des fils de phase et formation d'un connecteur ceinture entourant le circuit porté par le substrat.

2. Module selon la revendication 1, **caractérisé en ce que** la deuxième série d'éléments interrupteurs à puces (D) est fixée sur un deuxième élément électriquement conducteur pour définir un deuxième demi-pont (N,P).

3. Module selon la revendication 1, **caractérisé en ce que** chaque interrupteur (D2) de la deuxième série d'éléments interrupteurs à puces est fixée sur un troisième élément électriquement conducteur (0) relié à l'une des phases de l'alternateur, et **en ce que** chaque interrupteur (D1) de la première série d'éléments interrupteurs à puces est reliée à l'un des troisième dits éléments.

4. Module selon la revendication 3, **caractérisé en ce que** chaque interrupteur de la deuxième série d'éléments interrupteurs à puces est relié à un quatrième élément conducteur.

5. Module selon l'une quelconque des revendications précédentes, **caractérisé en ce que** les éléments interrupteurs à puces (D) d'un demi-pont (N,P) sont brasés sur une même pièce métallique (7) rapportée sur une trace métallique (9) du substrat.

6. Module selon la revendication 5, **caractérisé en ce qu'**une pièce métallique (8) est brasée au dessus d'une puce.

7. Module selon l'une des revendications précédentes, **caractérisé en ce qu'**une pièce intermédiaire est interposée entre un élément interrupteur à puce et une connexion électrique.

8. Module selon l'une des revendications précédentes, **caractérisé en ce que** le substrat comporte une zone (6) non isolée.

9. Module selon l'une quelconque des revendications précédentes, **caractérisé en ce que** l'enceinte comporte au moins une trace (CR) surmoulée ou clipsée et intégrée à une borne permettant la transmission du courant vers la batterie du véhicule et le réseau de bord.

10. Module selon l'une quelconque des revendications précédentes, **caractérisé en ce qu'**il comporte un capot (CA) apte à fermer l'enceinte (C).

11. Module selon l'une quelconque des revendications précédentes, **caractérisé en ce que** l'enceinte (C), intègre des moyens de connexion (Tra) à un porte-balais (PB).

12. Module selon l'une quelconque des revendications précédentes des revendications 9 à 11, **caractérisé en ce qu'**il comporte un porte-balais (PB).

13. Module selon l'une quelconque des revendications précédentes, **caractérisé en ce que** les éléments interrupteurs à puces (D) consistent en des diodes similaires ou en des transistors MOS-FET non encapsulés.

14. Module selon l'une quelconque des revendications 1 à 13, **caractérisé en ce que** le module porte également des moyens de régulation (R).

15. Assemblage comportant un module électronique et un alternateur doté d'un palier (PA) avant et arrière, **caractérisé en ce que** ce module est un module selon l'une des revendications précédentes porté par l'un des paliers avant et arrière de l'alternateur.

16. Assemblage selon la revendication 15, **caractérisé en ce que** des canaux de ventilation (CAV) interviennent entre le module et le palier arrière de l'alternateur.

17. Assemblage selon l'une des revendications 15 ou 16, **caractérisé en ce que** le refroidissement par eau ou par air de l'alternateur est apte à refroidir les éléments formant diodes.

## Claims

1. Electronic module for a vehicle alternator, especially a car alternator, equipped with phase wires, comprising a circuit which incorporates an AC/DC current converter (P, N, D) equipped with switching elements (D) borne by an insulated substrate (S), in which the switching elements (D) take the form of two sets of unencapsulated chips, **characterized in that** at least a first of the two sets of said chip switching elements is mounted on a first electrically conductive element (7) so as to define a first half-bridge (P, N), **in that** the first electrically conductive element (7) is connected to a conductive track (9, TN) on the insulated substrate (S), and **in that** the substrate (S) bears an enclosure (C), made of a plastic, which enclosure surrounds the circuit that the substrate bears and which integrates connection means comprising overmoulded or clip-fastened tracks forming hooks (CR) for attachment of the phase wires and forming an encircling connector that surrounds the circuit borne by the substrate.

2. Module according to Claim 1, **characterized in that** the second set of chip switching elements (D) is attached to a second electrically conductive element so as to define a second half-bridge (N, P).

3. Module according to Claim 1, **characterized in that** each switch (D2) of the second set of chip switching elements is attached to a third electrically conductive element (O) connected to one of the alternator phases, and **in that** each switch (D1) of the first set of chip switching elements is connected to one of said third elements.

4. Module according to Claim 3, **characterized in that** each switch of the second set of chip switching elements is connected to a fourth conducting element.

5. Module according to any one of the preceding claims, **characterized in that** the chip switching elements (D) of a half-bridge (N, P) are soldered onto one and the same metal part (7) connected to a metal track (9) on the substrate.

6. Module according to Claim 5, **characterized in that** a metal part (8) is soldered onto a chip.

7. Module according to one of the preceding claims, **characterized in that** an intermediate piece is interposed between a chip switching element and an electrical connection.

8. Module according to one of the preceding claims, **characterized in that** the substrate comprises an uninsulated region (6).

9. Module according to any one of the preceding claims, **characterized in that** the enclosure comprises at least one overmoulded or clip-fastened track (CR) integrated into a terminal enabling transmission of the current to the battery of the vehicle and the onboard network.

10. Module according to any one of the preceding claims, **characterized in that** it comprises a cover (CA) able to cap the enclosure (C).

11. Module according to any one of the preceding claims, **characterized in that** the enclosure (C) incorporates means (Tra) of connecting a brush holder (PB).

12. Module according to any one of Claims 9 to 11, **characterized in that** it comprises a brush holder (PB).

13. Module according to any one of the preceding claims, **characterized in that** the chip switching elements (D) consist of similar diodes or of unencapsulated MOSFET transistors.

14. Module according to any one of claims 1 to 13, **characterized in that** the module also bears regulating means (R).

15. Assembly comprising an electronic module and an alternator equipped with a front and a back plate (PA), **characterized in that** this module is a module, according to one of the preceding claims, borne by one of the front/back plates of the alternator.

16. Assembly according to Claim 15, **characterized in that** ventilation channels (CAV) are provided between the module and the back plate of the alternator.

17. Assembly according to either one of Claims 15 and 16, **characterized in that** water or air cooling of the alternator is able to cool the elements that form diodes.

## Patentansprüche

1. Elektronisches Modul für einen Wechselstromgenerator eines Fahrzeugs, insbesondere eines Kraftfahrzeugs, das mit Phasendrähten versehen ist, mit einer Schaltung, die einen Wechselstrom-Gleichstrom-Wandler (P,N, D) umfasst, der mit von einem isolierten Substrat (S) getragenen Schalterelementen (D) versehen ist, wobei die Schalterelemente (D) in Form von zwei Reihen von nicht eingekapselten Chips vorliegen, **dadurch gekennzeichnet, dass** mindestens eine erste der zwei Reihen der Chip-Schalterelemente auf ein erstes elektrisch leitendes Element (7) montiert ist, um eine erste Halbbrücke (P,N) zu definieren, dass das erste elektrisch leitende Element (7) auf eine leitende Spur (9,TN) des isolierten Substrats (S) aufgebracht ist, dass das Substrat (S) eine Umschließung (C) aus einem Kunststoffmaterial trägt, die die vom Substrat getragene Schaltung umgibt und die Anschlusseinrichtungen umfasst, die aufgeformte oder clipbefestigte Spuren enthalten, die Haken (CR) zur Befestigung der Phasendrähte und zur Bildung eines Ringverbinders formen, der die vom Substrat getragene Schaltung umgibt.

2. Modul nach Anspruch 1, **dadurch gekennzeichnet, dass** die zweite Reihe von Chip-Schalterelementen (D) an einem zweiten elektrisch leitenden Element befestigt ist, um eine zweite Halbbrücke (N,P) zu definieren.

3. Modul nach Anspruch 1, **dadurch gekennzeichnet, dass** jeder Schalter (D2) der zweiten Reihe von Chip-Schalterelementen an einem dritten elektrisch leitenden Element (0) befestigt ist, das mit einer der Phasen des Wechselstromgenerators verbunden ist, und dass jeder Schalter (D1) der ersten Reihe von Chip-Schalterelementen mit einem der dritten Elemente verbunden ist.

4. Modul nach Anspruch 3, **dadurch gekennzeichnet, dass** jeder Schalter der zweiten Reihe von Chip-Schalterelementen mit einem vierten leitenden Element verbunden ist.

5. Modul nach einem der vorhergehenden Ansprüche, **dadurch gekennzeichnet, dass** die Chip-Schalterelemente (D) einer Halbbrücke (N,P) auf das gleiche metallische Bauteil (7) gelötet sind, das auf eine metallische Spur (9) des Substrats aufgebracht ist.

6. Modul nach Anspruch 5, **dadurch gekennzeichnet, dass** ein metallisches Bauteil (8) über einen Chip gelötet ist.

7. Modul nach einem der vorhergehenden Ansprüche, **dadurch gekennzeichnet, dass** ein Zwischenbauteil zwischen ein Chip-Schalterelement und eine elektrische Verbindung eingefügt ist.

8. Modul nach einem der vorhergehenden Ansprüche, **dadurch gekennzeichnet, dass** das Substrat eine nicht isolierte Zone (6) aufweist.

9. Modul nach einem der vorhergehenden Ansprüche, **dadurch gekennzeichnet, dass** die Umschließung mindestens eine Spur (CR) aufweist, die aufgeformt oder clipbefestigt und in eine Klemme integriert ist, die die Übertragung des Stroms zur Batterie des Fahrzeugs und zum Bordnetz ermöglicht.

10. Modul nach einem der vorhergehenden Ansprüche, **dadurch gekennzeichnet, dass** es einen Deckel (CA) aufweist, der die Umschließung (C) verschließen kann.

11. Modul nach einem der vorhergehenden Ansprüche, **dadurch gekennzeichnet, dass** die Umschließung (C) Einrichtungen (Tra) zur Verbindung mit einem Bürstenhalter (PB) umfasst.

12. Modul nach einem der Ansprüche 9 bis 11, **dadurch gekennzeichnet, dass** es einen Bürstenhalter (PB) aufweist.

13. Modul nach einem der vorhergehenden Ansprüche, **dadurch gekennzeichnet, dass** die Chip-Schalterelemente (D) aus gleichartigen Dioden oder aus nicht eingekapselten MOS-FET-Transistoren bestehen.

14. Modul nach einem der Ansprüche 1 bis 13, **dadurch gekennzeichnet, dass** das Modul ebenfalls Regelungseinrichtungen (R) trägt.

15. Anordnung, die ein elektronisches Modul und einen Wechselstromgenerator aufweist, der mit einem vorderen und hinteren Lager (PA) versehen ist, **dadurch gekennzeichnet, dass** dieses Modul ein Modul nach einem der vorhergehenden Ansprüche ist, das von einem der vorderen und hinteren Lager des Wechselstromgenerators getragen wird.

16. Anordnung nach Anspruch 15, **dadurch gekennzeichnet, dass** Belüftungskanäle (CAV) zwischen dem Modul und dem hinteren Lager des Wechselstromgenerators zwischengefügt sind.

17. Anordnung nach einem der Ansprüche 15 oder 16, **dadurch gekennzeichnet, dass** die Wasser- oder Luftkühlung des Wechselstromgenerators die Dioden bildenden Elemente kühlen kann.
